# EUROPEAN PATENT APPLICATION

(11) **EP 0 778 608 A2**
(43) Date of publication of application: **11.06.1997**
(21) Application number: 96308856.2
(22) Date of filing: 05.12.1996
(51) Int. Cl.: H01J 37/32

(54) **Plasma generators and methods of generating plasmas**

(30) Priority: 06.12.1995 US 568004
(71) Applicant: APPLIED MATERIALS, INC., Santa Clara, California 95054-3299 (US)
(72) Inventor: Kanayama, Shuta, San Jose, California 95131 (US)
(74) Representative: Bayliss, Geoffrey Cyril

(57) **Abstract**

The disclosure relates to a plasma generator (10) which includes a vacuum chamber (12) having a plasma generation region (14) and at least one vacuum waveguide (16, 18) connecting to the vacuum chamber. The vacuum waveguide has a microwave introduction window (17, 19) connected at one end thereto. The vacuum chamber has walls (26, 28) defining a cavity (30) for causing a resonant condition for microwaves introduced from the vacuum waveguide. The vacuum chamber has a gas introduction inlet (48) connected to the plasma generation region. A target (32) having a perimeter (34) and a face (36) is disposed on one of the walls of the vacuum chamber with the face (36) exposed to the plasma generation. Preferably, the plasma generator also includes a generator (46) for establishing a magnetic field within the plasma generating region across the face (36) of the target. A method is also disclosed for generating a plasma within a magnetic field in a vacuum chamber proximate to a target having a perimeter and a face. The method includes the steps of providing a gas proximate to the face of the target; and, introducing microwaves about the perimeter of the target and directing the microwaves to create a plasma across the face of the target.

## Description

The present invention relates to a microwave plasma generator for semiconductor device substrate processing which is capable of producing a more intense plasma and, where used for physical vapor deposition, a more uniform deposition of sputtered material onto the substrate. More particularly, the present invention provides one or more vacuum waveguides to direct microwaves to an adjacent plasma generation region.

In many deposition processes, a process gas is introduced into a vacuum chamber to which a magnetic field from a magnetic coil, and an electric field from a microwave source, are applied. When exposed to the magnetic and electric fields in the vacuum chamber, the process gas is converted into plasma by the well-known electron cyclotron resonance (ECR) phenomenon. The ions generated by the plasma bombard a target which causes sputtering of the target material. Sputtered particles are removed from the target and are deposited on a substrate located in the vacuum chamber. The deposition of the sputtered particles onto the substrate forms a thin film.

When the process of physical vapor deposition (PVD) is used with ECR, the high density plasma used to sputter the target also ionizes at least a portion of the atoms sputtered from the target. This helps to overcome one problem with sputter methods. In traditional PVD, a target atom is sputtered from the target at a specific kinetic energy and it travels on a straight path until it collides with the substrate or internal chamber component. The trajectories or the target atoms sputtered from the target range from being parallel to perpendicular with respect to the substrate. Accordingly, only a portion of the target atoms strike the substrate with a perpendicular trajectory. As a result, deep narrow holes or trenches in the exposed surface of the substrate are usually not completely filled because the deposition of material from the target fills over the top of the hole, blocking access of later sputtered target atoms from the base of the hole. With ECR PVD, a higher percentage of the target atoms are ionized than occurs in traditional sputtering, which enables the use of a bias on the substrate to electrically attract the ions toward the substrate in paths perpendicular to the surface of the substrate to enable filling of narrow, deep holes or trenches.

One conventional film deposition apparatus is a planar magnetron sputtering apparatus which sputters a target having an initially planar surface exposed to a plasma. The target is sputtered by attraction of positively charged plasma ions to the negatively biased target surface. To enhance the sputtering phenomenon, a magnet structure is placed behind the target to create magnetic field lines which are wholly, or partly, parallel to the uneroded surface of the substrate. Electrons in the plasma become trapped about the magnetic field lines in orbital paths. When the electrons collide with a gas atom, the gas atom can be ionized. Typically, the magnetic field is created by placing magnets behind the target, the magnetic field lines between the poles being partially parallel to the exposed surface of the target. Thus, where the magnet is located, electrons are trapped and ionization and sputtering is locally increased. To improve sputter uniformity, the magnet is moved over the back of the target, preferably in a circular path. Thus, whenever the magnetic field is perpendicular to the electric field, sputter yield is enhanced.

An example of a conventional plasma generator for ECR sputtering is disclosed in U.S. Patent No. 4,492,620. Magnetic coils arranged along the side of a plasma formation chamber interact with a microwave electric field of a microwave introduced by a waveguide at one end of the chamber to create a plasma. The plasma is projected into a process chamber through an aperture positioned at the end of the plasma formation chamber opposite the microwave waveguide. One of the drawbacks of the disclosed apparatus is that the diameter of the wafer subject to sputtering is limited by the length of the apparatus since the size of the aperture limits the projection angle of plasma introduced into the process chamber. Therefore, the larger the substrate, the longer the chamber. Another drawback of the apparatus is that the magnetic field is not uniformly generated in the plasma region because of the physical distance and orientation of the plasma to the coils generating the magnetic field which are arranged at the side of the plasma formation chamber. Furthermore, the apparatus requires that the plasma be projected into a separate process chamber, increasing the complexity of the apparatus compared to a magnetron sputtering apparatus having a single wafer and a planar target.

Another example of an ECR apparatus is disclosed in Japanese Kokai Patent Application No. Hei 6[1994]-2128. In this apparatus, both the treatment gas and the microwave energy are supplied to the chamber through slit apertures in a microwave introduction window. Magnetic coils are provided to direct the lines of magnetic force onto targets located on the side walls of the apparatus. One of the problems with the apparatus is that the magnetic field is not uniform because magnetic coils are arranged at the side of the waveguide, away from the plasma formation chamber and the region of the substrate. As the physical distance between the plasma and magnetic coils increases, so does the difficulty of directing and maintaining a uniform field of magnetic force.

Another design of an ECR plasma source is disclosed in U.S. Patent No. 5,133,826. A magnetic field is formed by magnets circumferentially arranged about a cylindrical chamber with microwave power injected perpendicular to a longitudinal axis of the chamber for preventing line-of-sight communication of energetic electrons through an outlet at one axial end of the chamber. A magnetic field free region is required between the plasma forming region containing the microwave power source and the circumferential magnets to produce uniformity of plasma distribution in a plasma stream approaching the outlet. The disclosed magnetic field free region enlarges the chamber, however, increasing the physical distance between the magnets, the microwave source, and the speciman.

Further, in each case, the structure of the plasma formation chamber prevents the placement of magnets behind the substrate as is used in magnetron sputtering. Therefore, the ion-trapping effect of placing magnets behind the target cannot be used.

The need remains for allowing the deposition of film layers on larger substrates while providing a more controllable and uniform magnetic field than that available in the prior art. A few of the advantages of overcoming these problems is a higher quality thin film formation on the substrate and a more efficient manufacturing process with larger substrates.

Accordingly, the present invention provides, in one embodiment, a plasma generator which includes a vacuum chamber having a plasma generation region and a plurality of vacuum waveguides connecting to the vacuum chamber. Each vacuum waveguide has a microwave introduction window connecting at one end thereof to the vacuum chamber near the plasma generation region. The vacuum chamber has walls defining a cavity for causing a resonant condition for microwaves which may be introduced from the plurality of vacuum waveguides. The vacuum chamber has a gas introduction inlet connecting to the plasma generation region. A target having a perimeter and a face is disposed on one of the walls of the vacuum chamber with the face exposed to the plasma generation region. Each of the vacuum waveguides connects to the vacuum chamber near the perimeter of the target. Preferably, the target faces a substrate in a parallel relation of the sputtering surface to the substrate deposition surface.

In another embodiment of the present invention, the plasma generator includes means for establishing a magnetic field within the plasma generating region across the face of the target. Preferably, each microwave introduction window is disposed at a position beyond the reach of a straight line within the vacuum chamber from any point on the target.

In another embodiment of the present invention, the plasma generator includes a vacuum chamber having a plasma generation region and at least one vacuum waveguide connecting to the vacuum chamber. The vacuum waveguide has a microwave introduction window connected at one end thereof to the vacuum chamber near the plasma generation region. The vacuum chamber has walls defining a cavity for causing a resonant condition for microwaves to be introduced from the vacuum waveguide. The vacuum chamber has a gas introduction inlet connected to the plasma generation region. A target having a perimeter and a face is disposed on one of the walls of the vacuum chamber with the face exposed to the plasma generation region. The vacuum waveguide is connected to the plasma generation region near the perimeter of the target. A substrate holder is disposed within the vacuum chamber facing the target in a generally parallel position thereto. The substrate holder is adapted for supporting a substrate. The plasma generator also includes means for establishing a magnetic field within the plasma generation region between the target and the substrate holder. The magnetic field means is positioned behind the target on one of walls of the vacuum chamber. Preferably, the vacuum chamber includes a ring having a wall. Each microwave introduction window is disposed within the wall of the ring. The ring extends perpendicularly along a substantial portion of the perimeter of the target whereby microwaves are introduced by each microwave introduction window along a substantial portion of the perimeter of the target.

A method is also disclosed for generating a plasma in a vacuum chamber proximate to a target having a perimeter and a face. The method including the steps of providing a gas proximate to the face of the target; and, introducing microwaves along the perimeter of the target and directing the microwaves to create a plasma across the face of the target.

These, and other features and advantages of the invention will be apparent from the following description when read in conjunction with the accompanying drawings, wherein:
Fig. 1 is a schematic sectional view illustrating a plasma generator in accordance with the present invention;
Fig. 2 is a schematic sectional view isolating one embodiment of a magnetic field generator provided by the present invention;
Fig. 3 is a schematic sectional view illustrating another embodiment of a plasma generator having a magnetic field generator in a different position compared to Fig. 1 in accordance with the present invention;
Fig. 4 is a schematic sectional view illustrating another embodiment of a plasma generator without a magnetic field generator in accordance with the present invention;
Fig. 5 is a sectional view of the processing chamber, including a preferred embodiment of the microwave introduction windows of the present invention, positioned for processing a substrate therein; and
Fig. 6 is a cross-sectional view along lines 6-6 in Fig. 5 isolating the microwave distribution channel and multiple microwave introduction windows provided by the present invention.

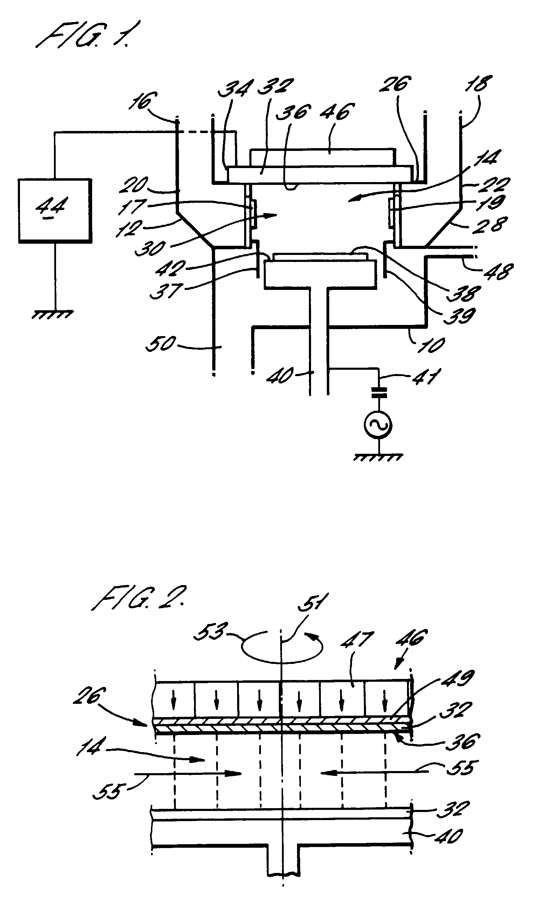

Referring now to Fig. 1, a plasma generator 10 in accordance with the present invention includes a vacuum chamber 12 defining a plasma generation region 14. A plurality of vacuum waveguides 16, 18 connect at ends 20, 22 thereof to the vacuum chamber 12 near the plasma generation region 14. Each vacuum waveguide 16, 18 includes one or more microwave introduction windows 17, 19. Each microwave introduction window includes a microwave transparent portion made of a material such as quartz. The portions of the vacuum chamber 10 exposed to the plasma generation region 14 should be made from process-compatible materials such as anodized aluminum.

The vacuum chamber 12 includes an upper wall 26 and side walls 28 which define a cavity 30 for causing a resonant condition for microwaves that are introduced from the vacuum waveguides 16, 18. The waveguides 16, 18 terminate in microwave introduction windows 17, 19 which form a ring. Preferably, each microwave introduction window 17, 19 forms an arcuate segment of a ring, such that one window is provided for each microwave source and the arcuate semi-annular extension of each window is equal to the number of microwave sources divided into 360 degrees. However, a different number of windows, or a different spacing of the windows, is specifically contemplated herein.

Preferably, the vacuum chamber 12 is rectangular, such that four side walls are provided, although other configurations are specifically illustrated herein. An upper electrode, including a target 32 of material to be sputtered and deposited on the substrate, is located within the perimeter of the windows 17, 19 and against the upper wall 26 of the vacuum chamber. Preferably, the target 32 is a plain electrode plate initially having a generally planar face 36 from which metal atoms may be sputtered as will be further discussed herein.

To provide energy to the vacuum chamber 12 and convert the gas therein into a plasma, microwave energy is supplied through the waveguides 16, 18 and windows 17, 19 from a microwave source such as a magnetron connected to a microwave introduction mechanism which can include a matching device, a microwave power meter, an isolator and so on (not shown) as is known to those skilled in the art. The microwaves introduced through the vacuum waveguides 16, 18 and windows 17, 19 simultaneously irradiate the plasma region along the perimeter 34 of the target from multiple directions and include components propagating in a plane parallel to the face 36 of the target. The result contributes to the creation of a higher density plasma compared to the prior art.

Although Fig. 1 depicts the vacuum waveguides 16, 18 connected to the same upper wall 26 upon which the target 32 is disposed, the present invention is not so limited. Nor is the present invention limited to the vacuum waveguides 16, 18 introducing the microwaves from behind the target 32. The vacuum waveguides can connect to other walls such as side wall 28 of the vacuum chamber. Furthermore, the microwaves can be introduced to the plasma generation region 14 from the side of the plasma generation region 14 or opposite the target 32.

The vacuum chamber 12 includes a susceptor or substrate holder 40 for supporting a substrate 38. Preferably, the substrate holder 40 is aligned in a parallel relationship to the target 32. The substrate holder 40 preferably is a conductive member having an upper surface 42 which can be exposed to the plasma generation region 14. The substrate holder 40 can incorporate a heater for heating the substrate 38. Furthermore, a DC or AC voltage can be applied to the substrate 38 as a bias potential in such instances as when a thin film is being formed on the substrate 38 or when sputter cleaning of the substrate 38 is being conducted. At least the upper surface 42 of the substrate holder is made from a process compatible material, such as anodized aluminum. A semiconductor wafer is preferably the substrate 38 supported by the upper surface 42 of the substrate holder for subsequent processing.

To prevent deposition of sputtered material in areas of the vacuum chamber 12 other than the substrate 38, one or more shields 37, 39 extend from the microwave introduction windows 17, 19 to the upper wall 26 of the vacuum chamber and to the plane in which the substrate holder 40 is aligned. Similar to the structure of the microwave introduction windows 17, 19, the shields 37, 39 form a wall. Each shield 37, 39 forms an arcuate segment of a ring, such that one shield is provided for each microwave introduction window and the arcuate semi-annular extension of each shield is equal to the number of microwave introduction windows divided into 360 degrees. However, a different number of shields, a different spacing of the shields, or a continuous shield is specifically contemplated herein.

A power supply 44 is connected to the target 32. The power supply 44 can be either DC or RF power. Optionally, the DC or RF power can be applied to only the substrate holder 40, applied only the upper electrode including the target 32, or applied to both the substrate holder and upper electrode as will be subsequently described in more detail. Another embodiment of the present invention does not use any DC or RF power. Preferably, however, the target 32 is supplied with a negative voltage potential relative to the substrate holder 40 for DC sputtering of the target. The substrate holder 40 is connected to an electrical bias 41. When using a RF power supply, it is coupled to a matching network which matches the impedance of the power supply to the impedance of the rest of the plasma generator 10.

The plasma generator 10 also preferably includes a magnetic field generator 46 for establishing a magnetic field within the plasma generating region 14 which is at least partially parallel to the face 32 of the target. The magnetic field generator 46 is positioned adjacent to the target 32 in a position directly behind or on top of the target 32 itself. In this illustrated embodiment, the lines of magnetic force extending between the poles of the magnetic field generator 46 extend at least partially parallel to the face 36 of the target so that microwaves introduced from the vacuum waveguides 16, 18 create a plasma in the chamber.

The intensity of the magnetic fields produced by the magnetic field generator 46 may be controlled such that the conditions for causing electron cyclotron resonance from the microwave energy being supplied to the vacuum chamber 12 can be established within the plasma generation region 14. For instance, the condition for causing electron cyclotron resonance of the microwave energy at a frequency of about 2.45GHz is a magnetic flux density of about 875G. Thus, an ECR (or microwave) source may be combined with magnets behind the target to sputter a planar target facing a planar substrate while the introduction of the microwaves from around the perimeter of the target provides a relatively uniform plasma across the target.

Various types of magnetic field generators 46 are suitable for use in the present invention. For example and not for limitation, a permanent magnet, an electromagnet, or magnetic material, or any combination of these magnetic field sources can be used as the magnetic field generator 46.

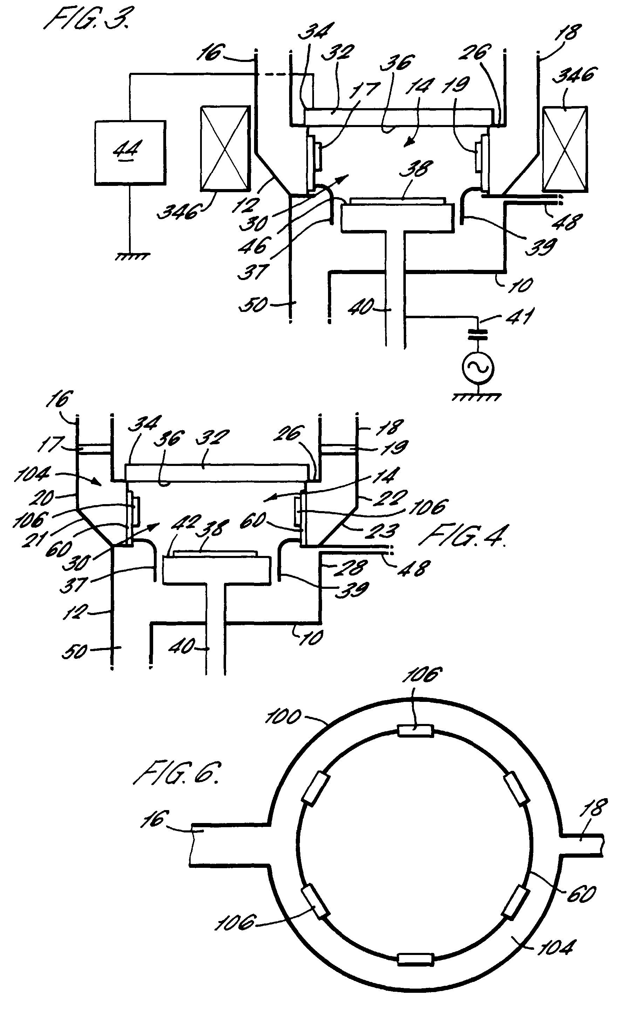

One example of a suitable magnetic field generator 46 is to position a magnetic source, such as one or more permanent magnets 47 as specifically illustrated in Fig. 2, on a revolving platform 49 adjacent the wall 26 of the vacuum chamber and behind the target 32. The magnets may have their poles attached to an inner and outer pole piece which form continuous N and S poles to increase the uniform distribution of the magnetic field. To reduce the spatial variation of process rate uniformity over the surface of the substrate 38, some sputtering systems, such as the model 5000E from Applied Materials, Inc., produce a magnetic field that is substantially parallel to the surface of the target 32 along a direction that rotates around an axis 51 that is concentric with and perpendicular to the target 32. This rotation as indicated by arrow 53 produces at the surface of the target 32 an approximately cylindrically symmetric time-averaged field that has improved average uniformity over the target 32, thereby producing improved process uniformity. The lines of magnetic force 55 from the magnetic field generator 46 extend across the face 36 of the target from a different position, but still provide a more intense plasma across the face 36 of the target when microwaves 55 are introduced from the vacuum waveguides through the microwave introduction windows to intersect the lines of magnetic force 55. The introduction of microwaves along the perimeter and across the face 36 of the target creates the plasma in the plasma generation region 14. A planar magnetron sputtering source producing improved coating thickness uniformity is disclosed in U.S. Patent No. 5,320,728 by Avi, said patent having the same assignee as the present invention and is incorporated herein by reference in its entirety.

Another example of a suitable magnetic field generator 46 includes placing magnetic material at a number of locations in the vacuum chamber 12 to adjust the magnetic field in the plasma generation region 14 and thereby change the distribution and properties of the ECR plasma as is well known in the art.

It is also preferred to incorporate additional magnetic material for plasma distribution and modification inside the substrate holder 40, because the close proximity of this magnetic material to the substrate 38 enables fine tuning of the rate of processing at each point of the substrate 38. Also, enclosing the magnetic material within the substrate holder 40 prevents the plasma from reacting with the magnetic material and the presence of such magnetic material within the vacuum chamber 12 will not contribute unwanted contamination into the wafer process. The size and uniformity of the magnetic field near the substrate 38 is dependent on the thickness of the added magnetic material, the magnetic permeability constant of the added magnetic material, and the spacing of this added magnetic material from the top surface of the substrate 38.

The vacuum chamber 12 includes a gas inlet manifold 48 for introducing the process gas separately and dispersing it for reaction with the microwaves within the plasma generation region 14. An exhaust manifold 50 connects to the vacuum chamber 12 to remove gas, ions, particulates, and other undesirable matter from the plasma generation region 14.

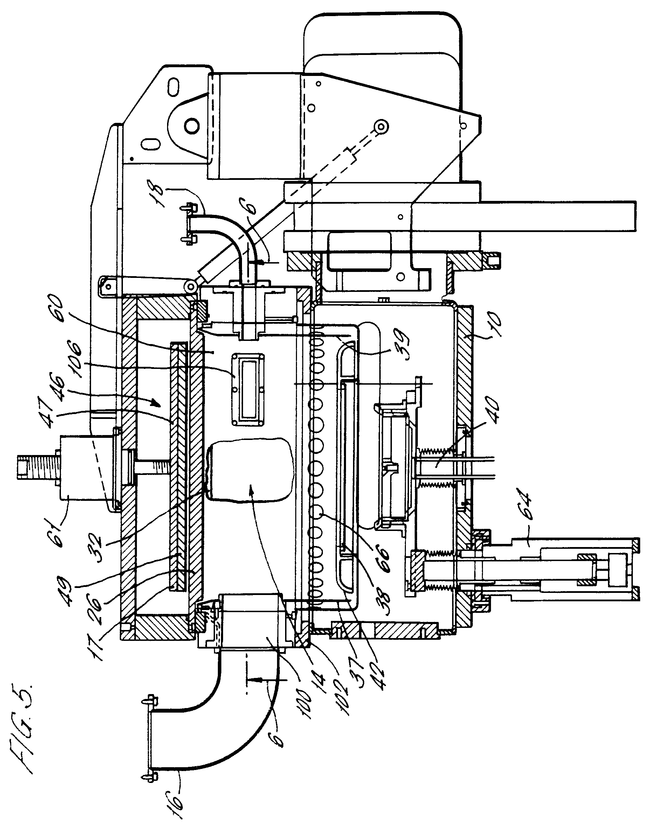

An alternate embodiment of the present invention is illustrated in Fig. 3. The same reference numerals used in Fig. 1 are also used to designate similar parts in Fig. 3. Referring now to Fig. 3, the magnetic field generator 346 is located in a different position relative to the target 32. The magnetic field generator 346 is positioned adjacent to the side wall 28 of the plasma generation region 14. The magnetic field generator 346 also is positioned in a perpendicular position relative to the target 32. Preferably, the lines of magnetic force from the magnetic field generator 346 extend across the face 36 of the target to provide the electron trap adjacent the surface of the target 32.

The embodiments of the present invention in Figs. 1 and 3 allow the positioning of the magnetic field generators 46, 346 closer to the target 32 by eliminating the need to position ECR structure behind or near the target as in the prior art. The present invention also positions the waveguides 16, 18 and windows 17, 19 in close proximity to the perimeter 34 of the target which eliminates the need for separate chambers for plasma formation and processing. As a result, the present invention provides advantages over the prior art such as the processing of film layers on larger substrates or wafers in a single vacuum chamber having a less complex design.

Fig. 4 illustrates another embodiment of the present invention wherein the same reference numerals used in Fig. 1 designate similar parts. In Fig. 4, a plasma is created using microwaves without any magnetic field generators. The introduction of microwaves along the perimeter 34 and across the face 36 of the target creates the plasma in the plasma generation region 14. The use of the magnetic field generators with the present invention is optional.

Fig. 4 also illustrates an embodiment of the present invention where each microwave introduction window 17, 19 is disposed at a position beyond the reach of a straight line extending within the vacuum chamber 12 from any point on the front face of the target 32. This arrangement prevents particles sputtered from the face of the target 32 from traveling in a straight line path, and then being deposited on the microwave introduction windows 17, 19. As a result, the present invention provides a high density plasma in closer proximity to the target than available in the prior art while preventing particles sputtered from the target from travelling in straight line paths to deposit on the microwave introduction windows.

The microwaves are introduced in Fig. 4 from one or more sources into the waveguides 16, 18. The microwaves are reflected by surfaces 21, 23 and directed into the plasma generation region 14 across the face 36 of the target. Any conventional material known to those skilled in the art for reflecting microwave energy is suitable for use as reflecting surfaces 21, 23.

Fig. 5 illustrates another embodiment of the present invention with a specific configuration for the waveguides 16, 18 wherein the same reference numerals used in Fig. 1 designate similar parts. A drive assembly 64 raises the substrate holder 40 and substrate 38 to a position adjacent exhaust ports 66. As previously discussed refering to Fig. 2, a motor 61 rotates the platform 49 adjacent the vacuum chamber behind target 32. The platform 49 includes one or more permanent magnets 47 mounted thereon.

Referring to Fig. 5, the waveguides 16 and/or 18 enter the vacuum chamber 12 through the side wall 102 of the chamber. A ring 60, preferably made of aluminum and having a diameter about equal to the diameter of the target 32, encircles the perimeter of the target 32 seen through the cut-away. The ring 60 is preferably a continuous annular member although the present invention also provides for discrete, segmented portions to encircle the periphery of the target 32. The ring 60 can be removed from the chamber during cleaning so that any build-up of deposited material on the microwave introduction windows can be removed.

Illustrated with more detail in Fig. 6, an annular microwave distribution channel 104 is formed between the ring 60 and the chamber wall 100. The channel 104 preferably has a uniform height and width, and is sized to enable microwaves to be distributed throughtout the channel 104 using a single microwave source and single waveguide 16 or 18.

The ring 60 includes a plurality of microwave introduction windows 106 which have a generally rectangular shape. Each window includes a microwave transparent portion made of a material such as quartz and a mounting bracket to attach the windows to the ring. The windows 106 are evenly spaced about the ring 60, to enable introduction of microwaves at even radial spacings about the target 32. Where the windows are rectangular but not square, they are preferably all aligned with their longer side disposed parallel to the face 36 of the target as specifically illustrated in Fig. 5 as window 106.

The multiple microwave introduction windows 106 introduce microwaves along a substantial portion of the perimeter and across the face 36 of the target to create the plasma in the plasma generation region 14. The position of the microwave introduction windows 106 along the entire periphery of the ring 60 provides simultaneous irradiation of a plasma region from multiple directions using a single chamber having a less complex design than found in the prior art.

Although two waveguides 16, 18 are illustrated as a preferred embodiment, the present invention provides for any combination of one or more waveguides connected to one or more microwave introduction windows, preferably by use of a distribution channel 104. However, each microwave introduction window can be separately ported to a waveguide. If multiple waveguides are used, the waveguides can be supplied with microwave energy by single or multiple sources.

In Fig. 5, a plasma may be formed in the chamber with the presence of magnetic field generator 46. The introduction of microwaves along the perimeter 34 and across the face 36 of the target creates the plasma in the plasma generation region 14. The use of the magnetic field generators with the present invention is optional, but preferred. By configuring the vacuum chamber such that the backside of the target is unencumbered by waveguides or other structural ECR impediments, the present invention enables placement of the structure of the magnetic field generator directly behind the target in contrast to the prior art. The result is a more controllable magnetic field and intense plasma across the target than is available in the prior art.

Referring again to Fig. 4, the ring 60 having a multitude of microwave introduction windows 106 can be positioned within the vacuum chamber as described above. The microwave distribution channel 104 is formed between the side wall 26 of the chamber and the ring 60. Use of the ring 60 in this embodiment is optional.

In operation, the magnetic field applied to the plasma generation chamber 14 by the magnetic field generator, 46 or 346, provides lines of magnetic force across the face of the target 32. The introduction of microwaves from multiple directions around the perimeter 36 of the target converts the process gas into a plasma. Since sputtered particles are efficiently generated, the target material is deposited at high speed on the substrate and rapidly form a film on the substrate 38.

The plasma generator of the present invention provides a means of generating ions of sputtered materials suitable for deposition processes. Preferably, the inventive plasma generator is used in a physical vapor deposition (PVD) sputtering apparatus or for ECR sputtering, and more particularly, with high density plasma ECR. The inventive plasma generator can also be used in plasma reaction chambers in which the gas flow is a process gas used for etching, chemical vapor deposition (CVD), or the like, and in which the introduced microwaves ionize the process gas. More particularly, the inventive plasma generator can be used in plasma etching, reactive ion etching, mode plasma etching and, in associated processes for etching semiconductor, conductor and dielectric materials. Another particularly useful application of the inventive plasma generator is with plasma-enhanced CVD processes wherein a low pressure reactant gas discharge is developed in an RF field.

One embodiment of the present invention is particularly applicable to CVD and etching processes. Refering to Fig. 1, the power supply 44 is removed and a permanent magnet is used as the magnetic field generator 46 which provides a structure with more compact exterior dimensions and less complex design than those found in the prior art. This simplified structure also reduces the manufacturing costs of the system. As previously discussed, a rotating platform having a magnetic source thereon can be substituted for the permanent magnet.

Another embodiment of the present invention is particularly useful with CVD and etching processing involving film layers of less than about 0.5 um. DC or RF power is applied only to the substrate holder 40. The DC or RF power provides the capability of independently controlling the formation of ionzied gas atoms by varying the bias potential on either the target 32 or substrate 38, or both. As previously discussed, any magnetic field generator 46 can be used such as a permanent magnet or a rotating platform with a magnetic source thereon.

A further embodiment of the present invention is particularly applicable to PVD processes. DC or RF power is applied only to the upper electrode including the target 32. In this embodiment, any magnetic source such as a permanent magnet or a rotating platform with a magnetic source thereon can be used as the magnetic field generator 46.

Still another embodiment of the present invention is particularly applicable to PVD processes involving film layers of less than about 0.5 um. DC or RF power is applied to only the substrate holder 40. As previously discussed, any magnetic source such as a permanent magnet or a rotating platform with a magnetic source thereon can be used as the magnetic field generator 46.

A method of the present invention generates a plasma within a magnetic field in a vacuum chamber proximate to the target defined by a periphery and a face. The method includes the steps of providing the process gas proximate to the face of the target and introducing microwaves along the periphery of the target. The microwaves are directed to create a plasma across the face of the target. Preferably, the microwaves are introduced from one or more locations along the periphery of the target. In one embodiment, the microwaves enter the chamber at one or more windows exposed to the target. In another embodiment, the windows are to the side of the target and the shield provides a reflective surface to redirect the microwaves over the face of the target.

The method may further include the step of generating a magnetic field from a source positioned behind the target. The magnetic field is developed within the plasma having flux lines, a portion of which are substantially parallel to the face of the target.

The method can also includes the step of aligning a substrate having a substrate holder disposed within the vacuum chamber facing the target in a generally parallel position thereto. As a result, the step of introducing microwaves directs the microwaves between the face of the target and the aligned substrate. In DC sputtering, a negative voltage is applied to the target relative to the substrate.

While particular embodiments and applications of the present applications of the present invention have been illustrated and described, it is to be understood that the invention is not limited to the precise construction disclosed herein and that various modifications, changes, and variations will be apparent to those skilled in the art may be made in the arrangement, operation, and details of construction of the invention disclosed herein without departing from the spirit and scope of the invention as defined in the appended claims.

## Claims

1. A plasma generator comprising:
a vacuum chamber having a plasma generation region and at least one waveguide connecting to the vacuum chamber, said waveguide having a microwave introduction window connecting at one end thereof to the vacuum chamber near the plasma generation region, the vacuum chamber having walls defining a cavity for causing a resonant condition for microwaves to be introduced from said waveguide, the vacuum chamber having a gas introduction inlet connecting to the plasma generation region;
a target having a perimeter and a face, the target being disposed on one of the walls of the vacuum chamber with the face exposed to the plasma generation region, said waveguide connects to the vacuum chamber near the perimeter of the target, wherein microwaves exiting said microwave introduction window into said chamber are directed across said face of said target.

2. The plasma generator of claim 1 wherein each microwave introduction window is disposed at a position beyond the reach of a straight line within the vacuum chamber from any point on the face of the target.

3. The plasma generator of claim 2 wherein the plasma generator further includes a reflector within said chamber for reflecting microwaves exiting said window across said face of said target.

4. The plasma generator of claim 1 wherein said waveguide introduces the microwaves along a substantial portion of the perimeter of the target.

5. The plasma generator of claim 1 wherein the end of said waveguide connects to the same wall of the vacuum chamber on which the target is disposed.

6. The plasma generator of claim 1 wherein the plasma generator further includes a substrate holder disposed within the vacuum chamber in proximity to the target.

7. The plasma generator of claim 1 wherein the vacuum chamber includes:
a ring having a wall;
a microwave distribution channel defined by said ring in combination with said chamber surfaces;
said microwave introduction window disposed within the wall of the ring to enable passage of microwaves from said channel therethrough, the ring extending about the perimeter of the target whereby microwaves are introduced across the face of the target.

8. The plasma generator of claim 7 wherein said ring includes a plurality of microwave introduction windows extending through the wall of said ring.

9. The plasma generator of claim 1 wherein the plasma generator includes a plurality of waveguides directed to a plurality of microwave introduction windows.

10. The plasma generator of claim 9 wherein the plasma generator includes a single microwave source which supplies the plurality of waveguides.

11. A plasma generator comprising:
a vacuum chamber having a plasma generation region and at least one waveguide connecting to the vacuum chamber, said waveguide having a microwave introduction window connecting at one end thereof to the vacuum chamber near the plasma generation region, the vacuum chamber having walls defining a cavity for causing a resonant condition for microwaves to be introduced from said waveguide, the vacuum chamber having a gas introduction inlet connecting to the plasma generation region;
a target having a perimeter and a face, the target being disposed on one of the walls of the vacuum chamber with the face exposed to the plasma generation region; and
a magnetic field generator for generating magnetic field lines having a component extending across the face of the target.

12. The plasma generator of claim 11 wherein said microwave introduction window is disposed at a position beyond the reach of a straight line within the vacuum chamber from any point on the face of the target.

13. The plasma generator of claim 11 wherein the magnetic field generator is positioned adjacent to a surface of the target which is not exposed to a plasma during operation of the plasma generator.

14. The plasma generator of claim 11 wherein the magnetic field generator is disposed along the walls of the vacuum chamber generally perpendicular to the target.

15. The plasma generator of claim 11 wherein a plurality of waveguides introduce the microwaves at multiple positions about the perimeter of the target.

16. The plasma generator of claim 15 wherein the ends of the plurality of waveguides connect to the same wall of the vacuum chamber on which the target is disposed.

17. The plasma generator of claim 11 wherein the plasma generator further includes a substrate holder disposed within the vacuum chamber in proximity to the target.

18. The plasma generator of claim 11 wherein the vacuum chamber includes:
a ring having a wall;
said microwave introduction window disposed within the wall of the ring to enable passage of microwaves therethrough, the ring extending about the perimeter of the target whereby microwaves are introduced across the face of the target.

19. The plasma generator of claim 18 wherein the plasma generator includes a microwave distribution channel defined by said ring in combination with said chamber surfaces.

20. A plasma generator comprising:
a vacuum chamber having a plasma generation region and at least one waveguide connecting to the vacuum chamber, said waveguide having a microwave introduction window connecting at one end thereof to the vacuum chamber near the plasma generation region, said vacuum chamber having walls defining a cavity for causing a resonant condition for microwaves to be introduced from said waveguide, said vacuum chamber having a gas introduction inlet connecting to the plasma generation region;
a target having a perimeter and a face, the target being disposed on one of the walls of the vacuum chamber with the face exposed to the plasma generation region, said waveguide connects to said vacuum chamber near the perimeter of the target:
a substrate holder disposed within said vacuum chamber facing the target in a generally parallel position thereto, the substrate holder adapted for supporting a substrate; and
means for establishing a magnetic field within the plasma generating region between the target and the substrate holder, the magnetic field means being positioned behind the target on one of walls of said vacuum chamber.

21. The plasma generator of claim 20 wherein the end of said waveguide connects to the same wall of the vacuum chamber on which the target is disposed.

22. The plasma generator of claim 20 wherein the microwave introduction window is disposed at a position beyond the reach of a straight line within the vacuum chamber from any point on the target.

23. The plasma generator of claim 20 wherein said waveguide introduces the microwaves across the face of the target along a substantial portion of the perimeter of the target.

24. The plasma generator of claim 20 wherein the vacuum chamber includes a ring having a wall, said microwave introduction window disposed within the wall of the ring to enable passage of microwaves therethrough, the ring extending about the perimeter of the target whereby microwaves are introduced across the face of the target.

25. The plasma generator of claim 24 wherein the plasma generator includes a microwave distribution channel defined by said ring in combination with said chamber surfaces, said waveguide directs the microwaves into the distribution channel which pass through said microwave introduction window of said ring.

26. A method for generating a plasma in a vacuum chamber proximate to a target having a perimeter and a face, the method including the steps of:
providing a gas proximate to the face of the target; and
introducing microwaves at multiple locations about the perimeter of the target and directing the microwaves to create a plasma across the face of the target.

27. The method of claim 26 wherein the method further includes the step of generating a magnetic field from a magnetic field generator positioned adjacent a non-sputtering surface at the target.

28. The method of claim 26 wherein the method further includes the step of generating a magnetic field from a magnetic field generator positioned partially along the perimeter of the target.

29. The method of claim 26 wherein the method further includes the step of aligning a substrate holder disposed within the vacuum chamber facing the target in a generally parallel position to the face thereof; and the step of introducing microwaves directs the microwaves between the face of the target and the aligned substrate holder.
